# EUROPÄISCHE PATENTSCHRIFT

(11) **EP 1 774 584 B1**
(45) Veröffentlichungstag und Bekanntmachung des Hinweises auf die Patenterteilung: **29.10.2014**
(21) Anmeldenummer: 05766971.5
(22) Anmeldetag: 06.07.2005
(51) Int. Cl.: H01L 21/60, H05K 3/40, H05K 3/24, H05K 3/28

(54) **VERFAHREN ZUR HERSTELLUNG EINES ELEKTRISCHEN BAUELEMENTS**
ELECTRIC COMPONENT PRODUCTION METHOD
PROCEDE DE PRODUCTION D'UN COMPOSANT ELECTRIQUE

(30) Priorität: 06.07.2004 DE 102004032706
(43) Veröffentlichungstag der Anmeldung: 18.04.2007
(73) Patentinhaber: EPCOS AG, 81669 München (DE)
(72) Erfinder: BRUNNER, Sebastian, A-8042 Graz (AT); FEICHTINGER, Thomas, A-8010 Graz (AT); PUDMICH, Günter, A-8580 Köflach (AT); SCHLICK, Horst, 1160 WIEN (AT); SCHMIDT-WINKEL, Patrick, 65510 Hünstetten (DE)
(74) Vertreter: Epping, Wilhelm
(86) Internationale Anmeldenummer: PCT/DE2005/001200
(87) Internationale Veröffentlichungsnummer: WO 2006/005317

(56) Entgegenhaltungen:
- EP-A- 0 332 559
- EP-A- 0 786 927
- WO-A-02/085811
- WO-A-2004/012211
- GB-A- 1 558 764
- US-A- 4 898 805
- US-A- 5 075 665
- US-A- 5 698 451
- US-A1- 2003 213 614
- US-B1- 6 224 703

## Beschreibung

Die Erfindung betrifft ein Verfahren zur Herstellung eines elektrischen Bauelements mit einem keramischen Grundkörper.

Aus der Druckschrift US 5,136,364 ist ein Verfahren zur Versiegelung von Bonding-Pads von integrierten Schaltkreisen mittels einer Passivierungsschicht bekannt. Dabei wird eine strukturierte Passivierungsschicht so aufgebracht, dass sie die Ecken des Bonding-Pads überlappt. Ein derartiges Verfahren ist relativ zeit- und kostenaufwendig, da es die strukturierte Erzeugung der Passivierungsschicht erfordert. Weiterhin offenbart die US-Druckschrift nicht die Herstellung von elektrokeramischen Bauelementen mittels des dort genannten Verfahrens.

US 2003/0213614 A1 offenbart ein Verfahren zur Erzeugung der Durchkontaktierungen und elektrisch leitenden Verbindungen, worin eine Dispersion mit leitfähigen Partikeln auf ein absorbierendes Material getropft wird.

Aufgabe der vorliegenden Erfindung ist es daher, ein Verfahren zur Herstellung eines elektrokeramischen Bauelements anzugeben, bei dem auf besonders einfache Weise eine Passivierungsschicht mit Kontakten zur elektrischen Anbindung erzeugt werden kann.

Diese Aufgabe wird erfindungsgemäß durch ein Verfahren mit den Merkmalen von Anspruch 1 gelöst. Vorteilhafte Ausgestaltungen des erfindungsgemäßen Verfahrens sind Gegenstand weiterer Ansprüche.

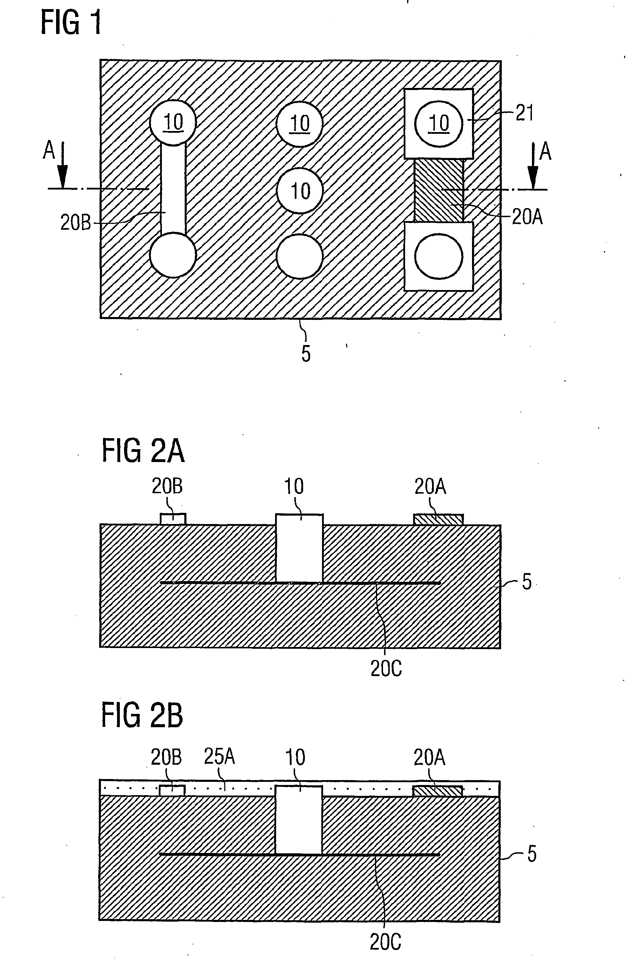

Die Erfindung beschreibt ein Verfahren zur Herstellung eines elektrischen Bauelements bei dem in einem Verfahrensschritt A) ein keramischer Grundkörper bereitgestellt wird, der im Inneren des Grundkörpers befindliche Durchkontaktierungen aufweist, die über die Oberfläche des Grundkörpers hinausreichen. Diese Durchkontaktierungen sind dabei elektrisch leitend mit Metallisierungsflächen verbunden, die beispielsweise auf der Oberfläche des Grundkörpers oder im Inneren des Grundkörpers angeordnet sein können. Diese Metallisierungsflächen bilden dabei Bauelementstrukturen. Diese Bauelementstrukturen können dabei zum Beispiel Innenelektroden, Widerstände, Spulen sowie Verbindungsleitungen zwischen verschiedenen Durchkontaktierungen umfassen (siehe z.B. Fig. 1). Bei dem erfindungsgemäßen Verfahren wird dann im Verfahrensschritt B) auf der Oberfläche des Grundkörpers ein elektrisch isolierendes erstes Material schichtförmig angeordnet, aus dem eine Passivierungsschicht gebildet werden kann. Das elektrisch isolierende erste Material wird dabei auch über der Durchkontaktierung angeordnet. Dann wird in einem Verfahrensschritt C) auf das erste Material ein elektrisch leitendes zweites Material über der Durchkontaktierung aufgebracht. Aus diesem elektrisch leitenden zweiten Material kann später ein Lötkontakt gebildet werden, der zur äußeren elektrischen Anbindung der Metallisierungsflächen mittels der Durchkontaktierungen dient. In einem Verfahrensschritt D) wird anschließend zumindest das zweite Material ausgehärtet, wobei aus dem zweiten Material ein Lötkontakt gebildet wird. Der Lötkontakt kontaktiert dabei elektrisch leitend die Durchkontaktierung.

Bei einem erfindungsgemäßen Verfahren kann somit das elektrisch isolierende erste Material für die Passivierungsschicht unstrukturiert über der Durchkontaktierung aufgebracht werden und anschließend der Lötkontakt oberhalb der Durchkontaktierung aus dem zweiten Material erzeugt werden. Somit ist bei einem erfindungsgemäßen Verfahren keine aufwendige strukturierte Aufbringung des ersten Materials für die Passivierungsschicht mehr nötig.

Dabei wird gemäß der ersten erfindungsgemäßen Alternative das erste Material gleich nach dessen Aufbringen auf dem keramischen Grundkörper ebenfalls im Verfahrensschritt B) ausgehärtet und daraus die Passivierungsschicht erzeugt. In diesem Fall wird das zweite Material dann auf die bereits ausgehärtete Passivierungsschicht über der zumindest einen Durchkontaktierung im Verfahrensschritt C) angeordnet. Bei dieser Variante des erfindungsgemäßen Verfahrens wird dann anschließend im Verfahrensschritt D) das zweite Material gehärtet, wobei sich das zweite Material und die bereits ausgehärtete Passivierungsschicht miteinander vermischen. Dies ist dann besonders einfach möglich, wenn das zweite Material oberhalb der Erweichungstemperatur der Passivierungsschicht ausgehärtet wird. Aufgrund dieser Vermischung wir dabei aus dem zweiten Material beim Aushärten ein Lötkontakt gebildet, der durch die Passivierungsschicht hindurch elektrisch leitend die Durchkontaktierung kontaktiert.

Alternativ wird im Verfahrensschritt C) das zweite Material auch über dem noch nicht ausgehärteten ersten Material aufgebracht. In diesem Fall können dann im Verfahrensschritt D) beide Materialien, das erste und zweite Material gemeinsam ausgehärtet werden, wobei es zu einer Vermischung beider Materialien kommt. Aufgrund der Vermischung wird auch hier ein Lötkontakt gebildet, der durch die Passivierungsschicht hindurch elektrisch leitend mit der Durchkontaktierung verbunden ist. Im Verfahrensschritt D) kann aber nach erfolgter Aufbringung des zweiten Materials auf dem ersten Material über der Durchkontaktierung zuerst das erste Material zu einer Passivierungsschicht ausgehärtet werden und erst anschließend das zweite Material zum Lötkontakt ausgehärtet werden. Dies ist besonders gut dann durchführbar, wenn die Aushärtungstemperatur für den Lötkontakt höher ist als die Aushärtungstemperatur für die Passivierungsschicht. Dann kann es zu einer Erweichung der Passivierungsschicht während des Aushärtens des zweiten Materials kommen, so dass eine Durchmischung zwischen der Passivierungsschicht und dem zweiten Material besonders gut gewährleistet werden kann.

Die aus dem ersten Material gebildete Passivierungsschicht kann dabei zur zusätzlichen Passivierung der Oberfläche des Bauelements und zum Schutz von äußeren Einflüssen, zum Beispiel Feuchte, Flussmitteln aber auch Säuren und Laugen dienen. Die Lötkontakte auf dem mittels des erfindungsgemäßen Verfahrens hergestellten Bauelementen können für Land Grid Arrays (LGA) und/oder Ball Grid Arrays (BGA) verwendet werden.

In einer Variante des erfindungsgemäßen Verfahrens werden in den Verfahrensschritten B) und C) erste und zweite Materialien verwendet, die fließfähige, härtbare Komponenten enthalten. Diese Komponenten können dabei chemisch und strukturell sehr ähnlich sein.

So ist es beispielsweise möglich als erstes Material für die Passivierungsschicht ein Material zu verwenden das eine Glaskomponente aufweist. Ebenso kann dann für das zweite Material des Lötkontakts beispielsweise eine Metallpaste verwendet werden, die Metallpartikel mit Glasanteilen umfasst. Der Glasanteil kann dabei ausgewählt sein aus Alumino-Silikat-Ggläsern, BoratGläsern, Boro-Silikat-Gläsern, Silikat-Gläsern, Zinkborat-Gläsern und Phosphatgläsern. Bei einer derartigen Kombination von ersten und zweiten Materialien mit Glasanteilen ist es dann besonders günstig in den Verfahrensschritten B) bzw. D) das erste und/oder zweite Material mittels Einbrennens auszuhärten, beispielsweise bei Temperaturen von etwa 600 bis 900 °C.

Abgesehen von Glasbestandteilen als härtbare Komponenten können auch beispielsweise noch Polymerbestandteile in dem ersten und zweiten Material verwendet werden. Die Polymere können dabei aus Harzen, Epoxidharzen, Polyurethanen, Silikonharzen, Parylenen, Thermoplasten, Polyamiden und Polyimiden ausgewählt sein. Als zweites Material wird dann bevorzugt ein Metalleitkleber verwendet, der normalerweise eine Metallmatrix in einem Polymer und eine Klebstoffkomponente, beispielsweise eine Epoxidharzkomponente, umfasst. Dabei sollte in den Verfahrensschritten B) bzw. D) dann das Einbrennen bei niedrigeren Temperaturen, beispielsweise bei etwa 150 bis 250 °C erfolgen.

Vorteilhafterweise umfassen das erste und zweite Material die gleiche härtbare Komponente, also z.B. Polymere oder Gläser. Dies ermöglicht ein besonders einfaches Herstellungsverfahren.

Besonders einfach ist eine elektrisch leitende Verbindung zwischen dem Lötkontakt und der Durchkontaktierung im Verfahrensschritt D) dann zu erreichen, wenn das erste Material der Passivierungsschicht bzw. die Passivierungsschicht selbst in einer Dicke von etwa 0,05 bis 10 µm auf der Oberfläche des keramischen Grundkörpers über der Durchkontaktierung aufgetragen wird. Bei derart dünnen Schichten ist es besonders einfach möglich im Verfahrensschritt D) eine elektrische Anbindung zwischen dem Lötkontakt und der Durchkontaktierung zu erreichen.

Im Verfahrensschritt A) einer Variante des erfindungsgemäßen Verfahrens kann der keramische Grundkörper durch Übereinanderstapeln von keramischen Schichten gebildet werden. In diesem Fall kann mittels einer derartigen Variante eines erfindungsgemäßen Verfahrens ein elektrokeramisches Mehrschichtbauelement aufgebaut werden. Der Vorteil eines derartig ausgebildeten Verfahrens besteht darin, dass die Metallisierungsflächen, die im elektrischem Kontakt mit den Durchkontaktierungen stehen, besonders einfach auf den einzelnen keramischen Schichten, beispielsweise mittels Siebdruckverfahren erzeugt werden können. In diesem Falle bilden die Metallisierungsflächen dann Innenelektroden, die im Inneren des keramischen Grundkörpers angeordnet sind.

Im Verfahrensschritt A) wird die Durchkontaktierung so erzeugt, dass sie über den keramischen Grundkörper hinausragt. Dies hat den Vorteil, dass eine oberhalb der Durchkontaktierung angeordnete erste Schicht zur Bildung der Passivierungsschicht dünner ausgebildet sein kann als an anderen Oberflächenbereichen des Grundkörpers, an denen keine Durchkontaktierungen vorhanden sind (siehe beispielsweise Figur 2B).

Die über die Oberfläche des Grundkörpers hinausragende Durchkontaktierung wird mittels folgendem Verfahren erzeugt. Es wird ein keramischer Grünkörper mit einer Durchbohrung bereitgestellt, in der eine elektrisch leitfähige Füllung für die Durchkontaktierung angeordnet ist. Dabei weist der keramische Grünkörper einen höheren Schwund während des Sinterns auf als die Füllung. Anschließend kann dann der Grünkörper und die Füllung ausgehärtet werden, wobei aufgrund des geringeren Schwunds der Füllung die daraus gebildete Durchkontaktierung über den, aus dem Grünkörper gebildeten keramischen Grundkörper hinausragt.

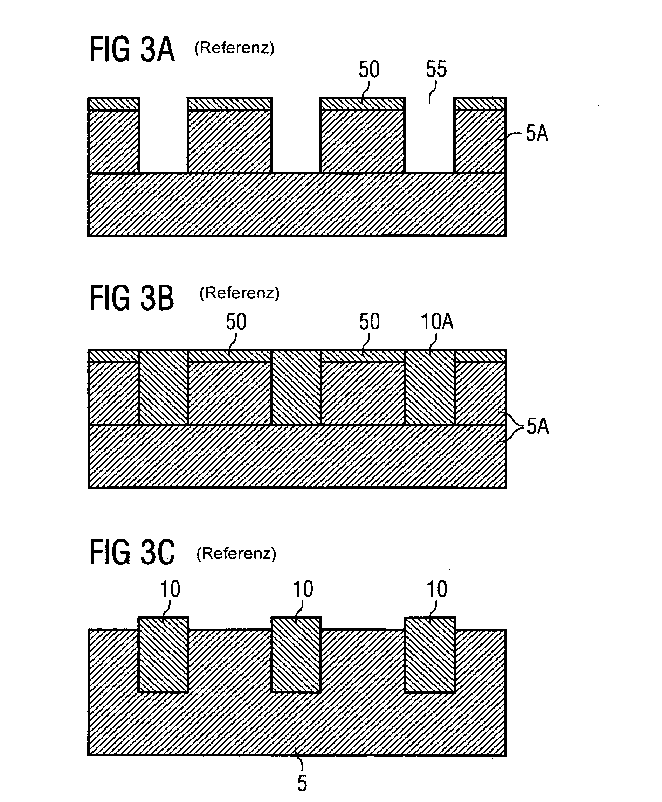

Eine andere als Referenz angegebene Möglichkeit, eine über den Grundkörper hinausragende Durchkontaktierung zu erzeugen, besteht darin, im Verfahrensschritt A) einen keramischen Grünkörper bereitzustellen, der eine auf dessen Oberfläche angeordnete Schablone und eine durch die Schablone durchreichende Durchbohrung umfasst. In der Durchbohrung ist eine elektrisch leitfähige Füllung auf ein höheres Niveau als die Oberfläche des Grünkörpers angeordnet. Anschließend werden dann der keramische Grünkörper und die Füllung ausgehärtet und dabei der Grünkörper mit der darüber hinausragenden Durchkontaktierung erzeugt. In diesem Fall können die elektrisch leitfähige Füllung in der Durchbohrung und der keramische Grünkörper einen ähnlichen Schwund während des Sinterns aufweisen. Aufgrund der auf der Oberfläche des keramischen Grünkörpers angeordneten Schablone kann allerdings mehr elektrisch leitfähige Füllung in die Durchbohrung eingebracht werden, so dass entweder nach der Verkohlung der Schablone während des Aushärtens oder nach dem Abziehen der Schablone nach dem Aushärten die Durchkontaktierung über die Oberfläche des keramischen Grundkörpers hinausstehen kann (siehe beispielsweise Figuren 3A bis 3C).

Optional kann nach dem Verfahrensschritt D) bei einer Variante eines erfindungsgemäßen Verfahrens in einem Verfahrensschritt E) zumindest eine Zwischenmetallschicht auf dem Lötkontakt erzeugt werden. Das Material dieser Zwischenmetallschicht kann beispielsweise ausgewählt sein aus Nickel, Palladium, Kupfer, Chrom, Silber und Gold. Diese zumindest eine Zwischenmetallschicht kann vorteilhafterweise beispielsweise mittels galvanischer Methoden auf dem Lötkontakt abgeschieden werden und dient dazu bei zukünftigen Lötschritten eine Verbesserung der Benetzung des Lötkontakts zu erreichen. Diese Zwischenmetallschicht kann dabei direkt auf dem Lötkontakt erzeugt werden oder es können zwischen der Zwischenmetallschicht und dem Lötkontakt noch beliebige weitere Schichten, beispielsweise Metallschichten erzeugt werden die unterschiedlichen Funktionen aufweisen.

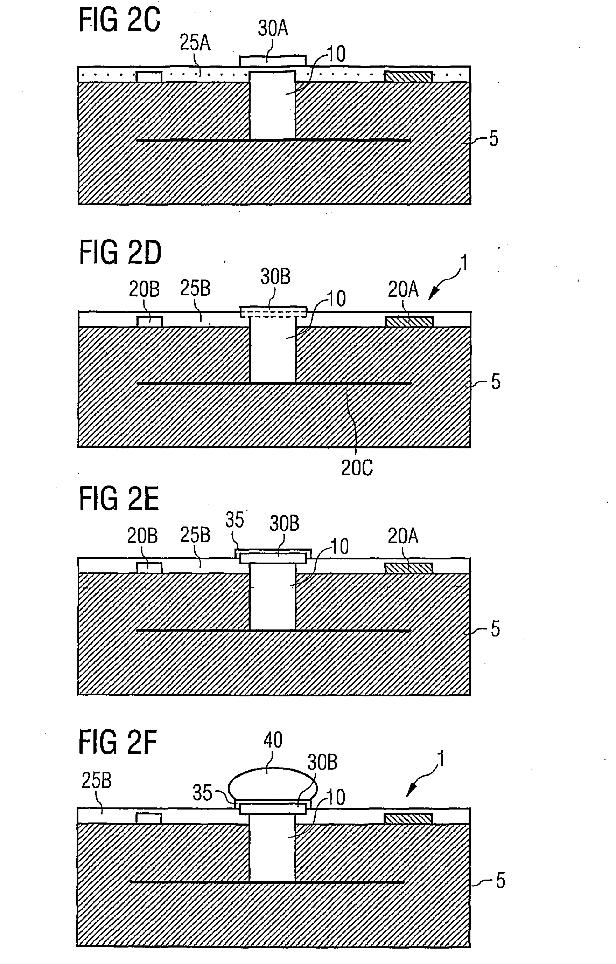

Günstigerweise kann nach einem Verfahrensschritt D) in einem Verfahrensschritt F) eine Lotkugel auf dem Lötkontakt erzeugt werden. Besonders günstig ist es, wenn diese Lotkugel nach dem optionalen Verfahrensschritt E) in dem die Zwischenmetallschicht aufgebracht wird, erzeugt wird, die Lötkugel somit oberhalb der Zwischenmetallschicht angeordnet wird (siehe beispielsweise Figur 2F). Derartige Lotkugeln können beispielsweise zur Montage des Bauelements auf einem Substrat mittels Flip-Chip-Montage eingesetzt werden. Im Verfahrensschritt F) wird dabei günstigerweise als Material für die Lotkugel ein Material verwendet, das ausgewählt ist aus Zinn (Sn) und den Legierungen Zinnblei (SnPb), Zinnsilberkupfer (SnAgCu), Zinnsilberkupferbismut (SnAgCuBi), Zinnzink (SnZn) und Zinnsilber (SnAg).

Im Verfahrensschritt A) kann als Material für die Durchkontaktierungen ein Material verwendet werden das ausgewählt ist aus Silber, Palladium, Platin, Silberpalladium (AgPd), Silberplatin (AgPt), Silberpalladiumplatin (AgPdPt), Nickel (Ni) und Kupfer (Cu). Vorteilhafterweise werden die Durchkontaktierungen gemeinsam mit dem keramischen Grünkörper ausgehärtet. Je nachdem ob für den keramischen Grünkörper niedrig sinternde oder hoch sinternde Keramiken verwendet werden, können dabei unterschiedliche Materialen für die Durchkontaktierungen verwendet werden. Beispielweise können bei niedrig sinternden Keramiken die Durchkontaktierungen Silber umfassen, während bei höher sinternden Keramiken temperaturbeständigere Materialen, beispielsweise Platin bevorzugt werden.

Der keramische Grundkörper des Bauelements kann vorteilhafterweise eine Elektrokeramik umfassen. Der keramische Grundkörper wird beispielsweise durch Übereinanderstapeln von keramischen Schichten gebildet. Das keramische Material kann dabei eine Varistorkeramik auf der Basis von Zinkoxid-Bismut ZnO-Bi oder Zinkoxid-Praseodym ZnO-Pr umfassen. Das keramische Material kann weiterhin eine Kondensatorkeramik umfassen die beispielsweise ausgewählt ist aus sogenannten NP0-Keramiken, zum Beispiel (Sm, Pa)NiCdO₃. Diese Keramiken weisen temperaturabhängige ε_{R}-Werte auf und sind nicht ferroelektrische Keramiken. Bei keramischen Kondensatoren ist weiterhin noch das Temperaturverhalten neben der Dielektrizitätskonstante entscheidend, wobei ein mittels des erfindungsgemäßen Verfahrens hergestellter keramischer Kondensator Keramikmaterialien umfasst die aus den Temperaturklassen COG, X7R, Z5U und Y5V ausgewählt sein können. Daneben oder alternativ kann das Bauelement auch Keramikschichten aus anderen Temperaturklassen enthalten.

Weiterhin können auch ferroelektrische Keramiken mit hohen Dielektrizitätskonstanten, sowie dotiertes Bariumtitanat BaTiO₃ und sogenannte Sperrschichtkeramiken verwendet werden. Derartige dielektrische Keramiken werden im Buch "Keramik" von H. Schaumburg (Herausgeber), B. G. Teubner Verlag, Stuttgart, 1994 auf den Seiten 351 bis 352 und 363 beschrieben, auf die hiermit vollinhaltlich Bezug genommen wird. Weiterhin kann das keramische Material auch Termistorkeramiken NTC-Keramiken, zum Beispiel Nickel-Mangan-Spinelle und Perowskite umfassen. Es können aber auch nichtkeramische dielektrische Materialien zum Beispiel Gläser eingesetzt werden.

Daneben können noch HTCC- oder LTCC-Keramiken in dem erfindungsgemäßen Verfahren für den keramischen Grundkörper verwendet werden. Außerdem kann im Verfahrensschritt A) als Material für den Grundkörper eine Ferritkeramik verwendet werden.

Ein Referenzbeispiel ist ein elektrisches Bauelement,
- mit einem Grundkörper,
- mit Metallisierungsflächen als Bauelementstrukturen,
- mit einer elektrisch isolierenden Passivierungsschicht auf der Oberfläche des Grundkörpers,
- mit Lötkontakten auf der Passivierungsschicht,
- mit im Inneren des Grundkörpers angeordneten Durchkontaktierungen, die elektrisch leitend mit den Metallisierungsflächen verbunden sind,
- wobei die Lötkontakte durch die Passivierungsschicht hindurch mit den Durchkontaktierungen elektrisch leitend verbunden sind.

Die Lötkontakte sind dabei vorteilhafterweise oberhalb der Durchkontaktierungen angeordnet. Wie bereits oben erwähnt kommt es während der Herstellung des Bauelements zu einer Vermischung der ersten und zweiten Materialien beziehungsweise des zweiten Materials und der Passivierungsschicht. Dabei vermischen sich unter anderem auch die elektrisch leitfähigen Anteile des zweiten Materials des Lötkontakts mit dem darunter befindlichen ersten Material beziehungsweise der Passivierungsschicht mit der Folge, dass die Konzentration der leitfähigen Bestandteile des Lötkontakts zur Durchkontaktierung hin abnimmt. Unter anderem anhand dieser "Verdünnung" lassen sich somit erfindungsgemäße Bauelemente von herkömmlichen Bauelementen unterscheiden. Der Vorteil dieser erfindungsgemäßen Bauelemente besteht darin, dass sie wesentlich einfacher und damit billiger herzustellen sind aber dennoch Lötkontakte mit einer guten elektrischen Verbindung zu den Durchkontaktierungen aufweisen.

Im folgenden soll die Erfindung anhand von Ausführungsbeispielen und Figuren noch näher erläutert werden. Die Figuren sind dabei nicht maßstabsgetreu und lediglich schematisch dargestellt.
- Figur 1: zeigt einen keramischen Grundkörper mit Bauelementstrukturen vor dem erfindungsgemäßen Verfahren in der Aufsicht.
- Figuren 2A bis 2F: zeigen eine Variante eines erfindungsgemäßen Herstellungsverfahrens im Querschnitt.
- Figuren 3A bis 3C: zeigen im Querschnitt die Herstellung von Durchkontaktierungen, die über die Oberfläche des keramischen Grundkörpers herausragen, nach einem Referenzverfahren.

Figur 1 zeigt in der Aufsicht einen keramischen Grundkörper 5 mit Bauelementstrukturen 20A und 20B und Durchkontaktierungen 10. Dabei sind im keramischen Grundkörper 5 Durchkontaktierungen 10 angeordnet, die bis an die Oberfläche des Grundkörpers reichen. Diese Durchkontaktierungen 10 sind dabei mit Metallisierungsflächen 20A und 20B verbunden die Bauelementstrukturen des Bauelements bilden. Die beiden hier sichtbaren Metallisierungsflächen sind dabei auf der Oberfläche des keramischen Grundkörpers 5 angeordnet, können aber beispielsweise auch im Inneren des Grundkörpers angeordnet sein (beispielsweise Innenelektroden 20C in Figur 2A). Die Metallisierungsflächen können beispielsweise eine Verbindungsleitung 20B oder ein Dickfilm-Bauelement, zum Beispiel einen Widerstand, NTC oder PTC 20A umfassen, das zusätzlich noch quadratische Kontaktflächen 21 aufweist. Das Bauelement ist dabei nach dem Verfahrensschritt A) des erfindungsgemäßen Verfahrens gezeigt, umfasst somit also noch keine Passivierungsschicht und darauf befindliche Lötkontakte.

Bezugnehmend auf die Figuren 2A bis 2F wird im folgenden der Verlauf einer Variante eines erfindungsgemäßen Verfahrens gezeigt. Dabei ist das elektrische Bauelement während der verschiedenen Verfahrensschritte in Querschnitten entlang der in Figur 1 mit A gekennzeichneten Linie gezeigt.

Figur 2A zeigt dabei das Bauelement nach dem Verfahrensschritt A) des erfindungsgemäßen Verfahrens. Es ist ein keramischer Grundkörper 5 vorhanden der wenigstens eine Durchkontaktierung 10 enthält, die in diesem Fall über die Oberfläche des Grundkörpers 5 hinausragt. Es ist auch möglich, dass die Durchkontaktierung 10 bündig mit der Oberfläche des Grundkörpers 5 abschließt. Diese Durchkontaktierung 10 ist elektrisch leitend mit einer Innenelektrode 20C verbunden. Weiterhin sind auch noch die anderen bereits in Figur 1 gezeigten Bauelementstrukturen 20A und 20 auf der Oberfläche des Bauelements zu erkennen. Die Ausgestaltung sowie Anzahl der Innenelektroden kann dabei je nach Funktion des Bauelements variieren. So können z. B. sich gegenüberstehende oder einander überlappende Elektroden in beliebiger Anzahl im Grundkörper vorhanden sein.

Figur 2B zeigt, wie im Verfahrensschritt B) auf der Oberfläche des Grundkörpers 5 ein elektrisch isolierendes erstes Material 25A aufgebracht wird, das sowohl die Durchkontaktierung 10 als auch die anderen Bauelementstrukturen 20B und 20A bedeckt. Dabei weist das erste Material 25A über der Durchkontaktierung eine geringere Schichtdicke auf, als an anderen Stellen, an denen keine Bauelementstrukturen auf der Oberfläche des Grundkörpers vorhanden sind.

Im Verfahrensschritt C) wird dann, wie in Figur 2C gezeigt ein zweites elektrisch leitendes Material 30A auf das erste elektrisch isolierende Material 25A über die Durchkontaktierung 10 aufgebracht. Aufgrund der Tatsache, dass die Durchkontaktierung 10 aus dem Grundkörper 5 herausragt ist die Schichtdicke des ersten Materials 25A oberhalb der Durchkontaktierung 10 dünner als an anderen Bereichen auf der Oberfläche des keramischen Grundkörpers 5. Dies ermöglicht besonders einfach ein Durchkontaktieren des Lötkontakts durch die Passivierungsschicht zur Durchkontaktierung 10 hin im Verfahrensschritt D) der in Figur 2D gezeigt ist.

Wie in Figur 2D gezeigt, wurden im Verfahrensschritt D) das erste Material 25A und das zweite Material 30A beispielsweise mittels Sinterns bei hohen Temperaturen ausgehärtet, wobei aus dem ersten Material 25A die Passivierungsschicht 25B und aus dem zweiten elektrisch leitenden Material 30A der Lötkontakt 30B gebildet wurde. Da sich erfindungsgemäß das erste und zweite Material miteinander während des Aushärtens vermischen kommt es dabei zu einer elektrisch leitenden Kontaktierung zwischen dem Lötkontakt 30B und der Durchkontaktierung 10, obwohl das zweite Material 30A des Lötkontakt 30B nicht direkt auf die Durchkontaktierung 10 sondern auf das erste Material 25A aufgetragen worden ist. Wie bereits oben genannt lässt sich diese Vermischung zwischen dem ersten und zweiten Material unter anderem dadurch leicht nachweisen, dass die Konzentration des elektrisch leitfähigen Materials des Lotkontakts 30B zur Durchkontaktierung 10 hin abnimmt. Das zweite Material 30A für den Lötkontakt kann beispielsweise eine Leitpaste umfassen, die Metallpartikel mit Glasfrittenanteilen enthält. In diesem Fall lässt sich besonders vorteilhaft als erstes Material 25A für die Passivierungsschicht 25B ebenfalls ein Material verwenden, das Glasanteile aufweist. Alternativ zu dem hier dargestellten Verfahren ist es aber auch möglich, bereits im Verfahrensschritt B) das elektrisch isolierende erste Material 25A auszuhärten. Dann wird dementsprechend im Verfahrensschritt D) das zweite Material 30A des Lötkontakts ausgehärtet, wobei das zweite Material in der Regel bei höheren Temperaturen ausgehärtet wird als das erste Material, so dass die bereits im Verfahrensschritt B) gebildete Passivierungsschicht dann ebenfalls fließfähig ist, so dass es zu einer Vermischung zwischen dem zweiten Material und der Passivierungsschicht und damit zu einer elektrisch leitenden Verbindung zwischen dem Lötkontakt 30B und der Durchkontaktierung 10 kommen kann. Aufgrund der Durchmischung der ersten und zweiten Materialien beim Aushärten ist keine klare Trennung zwischen dem Lötkontakt 30B und der Passivierungsschicht 25B mehr vorhanden, was in Figur 2D schematisch als gestrichelte Linie zwischen dem Lötkontakt und der Passivierungsschicht angedeutet ist.

Figur 2E zeigt im Querschnitt den optionalen Verfahrensschritt E), bei dem eine Zwischenmetallschicht 35 auf dem Lötkontakt 30B erzeugt wird. Diese Zwischenmetallschicht dient beispielsweise dazu in anschließenden Verfahrensschritten stattfindende Lötschritte zu erleichtern, da die Zwischenmetallschicht in der Regel eine gute Benetzbarkeit für Lote aufweist.

Bezugsnehmend auf Figur 2F ist die Erzeugung einer Lotkugel 40 auf der Zwischenmetallschicht 35 gezeigt. Diese Lotkugel 40 kann dazu dienen, das Bauelement 1 mittels Flip-Chip-Methoden auf einem Substrat aufzubringen.

Die Figuren 3A bis 3C zeigen ein Referenzverfahren, mit dem Durchkontaktierungen erzeugt werden können, die über dem Durchkontaktierungen keramischen Grundkörper herausragen.

In Figur 3A ist dabei ein noch nicht gesinterter, keramischer Grünkörper 5A der Durchbohrungen 55 aufweist, gezeigt. Auf dessen Oberfläche ist eine Schablone 50 angeordnet. Die Durchbohrungen 55 reichen dabei ebenfalls durch die Schablone 50 hindurch.

Bezugsnehmend auf Figur 3B werden elektrisch leitfähige Füllungen 10A in die Durchbohrungen 55 eingefüllt. Diese Füllungen 10A werden anschließend gemeinsam mit dem keramischen Grundkörper 5A ausgehärtet, beispielsweise gesintert. Dabei entsteht ein keramischer Grundkörper 5 mit über den Grundkörper herausragenden Durchkontaktierungen 10, wie in Figur 3C gezeigt. Die Schablone 50 kann dabei während des Sinterschrittes vergast werden oder, falls sie thermisch beständig ist nach dem Sinterschritt von dem keramischen Grundkörper 5 abgezogen werden.

Die vorliegende Erfindung beschränkt sich nicht auf die hier dargestellten Ausführungsbeispiele. Weitere Variationen im Rahmen der Patentansprüche sind beispielsweise möglich hinsichtlich der Ausgestaltung der mit den Durchkontaktierungen verbundenen Metallisierungsflächen.

## Patentansprüche

1. Verfahren zur Herstellung eines elektrischen Bauelements (1) mit den Verfahrensschritten:
A) ein keramischer Grundkörper (5) wird bereitgestellt, der zumindest eine über die Oberfläche des Grundkörpers hinausreichende Durchkontaktierung (10) und zumindest eine, mit der Durchkontaktierung elektrisch leitend verbundene Metallisierungsfläche (20A, 20B, 20C) enthält, wobei der Grundkörper (5) aus einem keramischen Grünkörper mit einer Durchbohrung hergestellt wird, worin eine elektrisch leitfähige Füllung angeordnet ist, wobei der keramische Grünkörper einen höheren Schwund während des Aushärtens aufweist als die Füllung, wobei anschließend der Grünkörper und die Füllung ausgehärtet werden und der Grundkörper (5) mit der darüber hinausragenden Durchkontaktierung (10) erzeugt wird
B) auf der Oberfläche des Grundkörpers (5) wird zumindest auf der Durchkontaktierung (10) ein elektrisch isolierendes erstes Material (25A) schichtförmig angeordnet,
C) auf das erste Material über der Durchkontaktierung (10) wird ein elektrisch leitendes zweites Material (30A) aufgebracht,
D) zumindest das zweite Material (30A) wird ausgehärtet, wobei ein Lötkontakt (30B) gebildet wird, der die Durchkontaktierung (10) elektrisch leitend verbindet, wobei jeweils unter Bildung einer Passivierungsschicht (25B) entweder das erste Material (25A) im Verfahrensschritt B) nach dessen Aufbringen auf den Grundkörper (5) oder im Verfahrensschritt D) zusammen mit dem zweiten Material (30A) ausgehärtet wird und wobei sich jeweils das zweite Material (30A) bei dessen Härtung mit dem ersten Material (25A) oder der daraus gebildeten Passivierungsschicht (25B) vermischt.

2. Verfahren nach einem der vorhergehenden Ansprüche, bei dem in den Verfahrensschritten B) und C) erste und zweite Materialien verwendet werden, die fließfähige, härtbare Komponenten enthalten.

3. Verfahren nach einem der vorhergehenden Ansprüche zur Herstellung eines Mehrschichtbauelements,
- wobei im Verfahrensschritt A) der keramische Grundkörper (5) durch Übereinanderstapeln vom keramischen Schichten gebildet wird.

4. Verfahren nach einem der vorhergehenden Ansprüche,
- bei dem in den Verfahrensschritten B) und C) als erstes Material Gläser und
- als zweites Material eine Metallpaste mit Glasanteilen verwendet wird.

5. Verfahren nach dem vorhergehenden Anspruch,
- bei dem im Verfahrensschritt D) das erste (25A) und zweite (30A) Material mittels Einbrennens bei etwa 600 bis 900°C ausgehärtet werden.

6. Verfahren nach einem der Ansprüche 4 oder 5,
- bei dem die Gläser ausgewählt sind aus Alumino-Silikatgläsern, Borat-Gläsern, Boro-Silikatgläsern, Silikat-Gläser, ZinkBorat-Gläser und Phosphat-Gläsern.

7. Verfahren nach einem der Ansprüche 1 bis 3,
- bei dem als erstes Material ein organisches Polymer und
- als zweites Material ein Leitkleber mit einer Polymermatrix verwendet wird.

8. Verfahren nach dem vorhergehenden Anspruch,
- bei dem im Verfahrensschritt D) das erste (25A) und zweite (30A) Material mittels Einbrennens bei etwa 150 bis 250°C ausgehärtet werden.

9. Verfahren nach einem der vorhergehenden Ansprüche,
- wobei nach dem Verfahrensschritt D) in einem Verfahrensschritt E) zumindest eine Zwischenmetallschicht (35) auf dem Lötkontakt (30B) erzeugt wird.

10. Verfahren nach dem vorhergehenden Anspruch,
- bei dem im Verfahrensschritt E) ein Material für die Zwischenmetallschicht (35) verwendet wird, das ausgewählt ist aus Ni, Pd, Cu, Cr, Ag und Au.

11. Verfahren nach einem der vorhergehenden Ansprüche,
- bei dem nach dem Verfahrensschritt D) in einem Verfahrensschritt F) eine Lotkugel (40) auf dem Lötkontakt (30B) erzeugt wird.

12. Verfahren nach dem vorhergehenden Anspruch,
- bei dem im Verfahrensschritt F) ein Material für die Lotkugel (40) verwendet wird, das ausgewählt ist aus Sn, SnPb, SnAgCu, SnAgCuBi, SnZn und SnAg.

13. Verfahren nach einem der vorhergehenden Ansprüche,
- bei dem im Verfahrensschritt A) ein Material für die Durchkontaktierungen (10) verwendet wird, das ausgewählt ist aus Ag, Pd, Pt, AgPd, AgPt, AgPdPt, Ni und Cu.

14. Verfahren nach einem der vorhergehenden Ansprüche zur Herstellung eines Varistors,
- bei dem im Verfahrensschritt A) ein Material für den Grundkörper (5) verwendet wird, das ausgewählt ist aus ZnO-Bi oder ZnO-Pr.

15. Verfahren nach einem der Ansprüche 1 bis 13 zur Herstellung eines Kondensators,
- bei dem im Verfahrensschritt A) ein Material für den Grundkörper verwendet wird, das ausgewählt ist aus den Temperaturklassen COG, X7R, Z5U, Y5V und HQM.

16. Verfahren nach einem der vorhergehenden Ansprüche,
- bei dem im Verfahrensschritt A) ein HTCC oder ein LTCC Material verwendet wird.

17. Verfahren nach einem der vorhergehenden Ansprüche,
- bei dem im Verfahrensschritt A) als Material für den Grundkörper eine Ferritkeramik verwendet wird.

## Claims

1. Method for producing an electrical component (1) comprising the following method steps:
A) a ceramic main body (5) is provided, which contains at least one through-contact (10) extending beyond the surface of the main body and at least one metallisation area (20A, 20B, 20C) electrically conductively connected to the through-contact, where the main body (5) is produced from a ceramic green body having a through hole, an electrically conductive filling being arranged therein, wherein the ceramic green body has a higher shrinkage during curing than the filling, wherein the green body and the filling are subsequently cured and the main body (5) with the through-contact (10) projecting beyond it is produced,
B) on the surface of the main body (5), at least on the through-contact (10), an electrically insulating first material (25A) is arranged in layer form,
C) an electrically conductive second material (30A) is applied to the first material above the through-contact (10),
D) at least the second material (30A) is cured, wherein a soldering contact (30B) is formed, which electrically conductively connects the through-contact (10), wherein, in each case with the formation of a passivation layer (25B), the first material (25A) is cured either in method step B) after it has been applied to the main body (5) or in method step D) together with the second material (30A) and wherein the second material (30A), during the curing thereof, in each case mixes with the first material (25A) or the passivation layer (25B) formed therefrom.

2. Method according to Claim 1,
wherein first and second materials containing flowable, curable components are used in method steps B) and C).

3. Method according to either of the preceding claims for producing a multilayer component,
- wherein, in method step A), the ceramic main body (5) is formed by ceramic layers being stacked one above another.

4. Method according to any of the preceding claims,
- wherein in method steps B) and C), glasses are used as first material and
- a metal paste comprising glass portions is used as second material.

5. Method according to the preceding claim,
- wherein, in method step D), the first material (25A) and second material (30A) are cured by means of firing at approximately 600 to 900°C.

6. Method according to either of Claims 4 and 5,
- wherein the glasses are selected from aluminosilicate glasses, borate glasses, borosilicate glasses, silicate glasses, zinc borate glasses and phosphate glasses.

7. Method according to any of Claims 1 to 3,
- wherein an organic polymer is used as first material and
- a conductive adhesive with a polymer matrix is used as second material.

8. Method according to the preceding claim,
- wherein, in method step D), the first material (25A) and second material (30A) are cured by means of firing at approximately 150 to 250°C.

9. Method according to any of the preceding claims,
- wherein, after method step D), in a method step E), at least one intermediate metal layer (35) is produced on the soldering contact (30B).

10. Method according to the preceding claim,
- wherein, in method step E), a material selected from Ni, Pd, Cu, Cr, Ag and Au is used for the intermediate metal layer (35).

11. Method according to any of the preceding claims,
- wherein, after method step D), in a method step F), a solder ball (40) is produced on the soldering contact (30B).

12. Method according to the preceding claim,
- wherein, in method step F), a material selected from Sn, SnPb, SnAgCu, SnAgCuBi, SnZn and SnAg is used for the solder ball (40).

13. Method according to any of the preceding claims,
- wherein, in method step A), a material selected from Ag, Pd, Pt, AgPd, AgPt, AgPdPt, Ni and Cu is used for the through-contacts (10).

14. Method according to any of the preceding claims for producing a varistor,
- wherein, in method step A), a material selected from ZnO-Bi or ZnO-Pr is used for the main body (5).

15. Method according to any of Claims 1 to 13 for producing a capacitor,
- wherein, in method step A), a material selected from the temperature classes COG, X7R, Z5U, Y5V and HQM is used for the main body.

16. Method according to any of the preceding claims,
- wherein an HTCC material or an LTCC material is used in method step A).

17. Method according to any of the preceding claims,
- wherein a ferrite ceramic is used as material for the main body in method step A).

## Revendications

1. Procédé de fabrication d'un composant électrique (1), le procédé présentant les étapes suivantes :
A) un corps cru (5) en céramique traversé par au moins un contact (10) qui déborde au-delà de la surface du corps cru et présentant au moins une surface de métallisation (20A, 20B, 20C) reliée de manière électriquement conductrice au passage de contact est préparé, le corps cru (5) étant réalisé à partir d'un corps cru en céramique traversé par un alésage dans lequel une charge électriquement conductrice est placée, le corps cru en céramique présentant pendant le durcissement un retrait plus élevé que la charge, le corps cru et la charge étant ensuite durcis et le corps cru (5) duquel le passage de contact (10) déborde est formé,
B) un premier matériau électriquement isolant (25A) est disposé en couches au moins sur le passage de contact (10) à la surface du corps cru (5),
C) un deuxième matériau électriquement conducteur (30A) est appliqué sur le premier matériau au-dessus du passage de contact (10),
D) au moins le deuxième matériau (30A) est durci, ce qui forme un contact brasé (30B) qui relie de manière électriquement conductrice le passage de contact (10), et avec la formation d'une couche de passivation (25B), le premier matériau (25A) de l'étape B) est durci après son application sur le corps cru (5) ou à l'étape D) en même temps que le deuxième matériau (30A), le deuxième matériau (30A) se mélangeant lors de son durcissement avec le premier matériau (25A) ou avec la couche de passivation (25B) qui en est formée.

2. Procédé selon la revendication 1, dans lequel on utilise dans les étapes B) et C) du traitement des deuxièmes matériaux qui contiennent des composants fluides durcissables.

3. Procédé selon l'une des revendications précédentes, destiné à fabriquer un composant multicouche, dans lequel au cours de l'étape A), le corps (5) cru en céramique est formé par superposition de couches céramiques.

4. Procédé selon l'une des revendications précédentes, dans lequel au cours des étapes B) et C), on utilise du verre comme premier matériau et une pâte métallique additionnée de verre comme deuxième matériau.

5. Procédé selon la revendication précédente, dans lequel à l'étape D), le premier matériau (25A) et le deuxième matériau (30A) sont durcis par cuisson entre 600 et 900°C.

6. Procédé selon l'une des revendications 4 ou 5, dans lequel les verres sont sélectionnés parmi les verres à l'aluminosilicate, les verres au borate, les verres au borosilicate, les verres au silicate, les verres au borate de zinc et les verres au phosphate.

7. Procédé selon l'une des revendications 1 à 3, dans lequel comme premier matériau, on utilise un polymère organique et comme deuxième matériau un adhésif conducteur doté d'une matrice polymère.

8. Procédé selon la revendication précédente, dans lequel à l'étape D), le premier matériau (25A) et le deuxième matériau (30A) sont durcis par cuisson entre environ 150 et 250°C.

9. Procédé selon l'une des revendications précédentes, dans lequel après l'étape D), au moins une couche métallique intermédiaire (35) est formée sur le contact brasé (30B) dans une étape de traitement E).

10. Procédé selon la revendication précédente, dans lequel à l'étape E), on utilise pour la couche métallique intermédiaire (35) un matériau sélectionné parmi Ni, Pd, Cu, Cr, Ag et Au.

11. Procédé selon l'une des revendications précédentes, dans lequel après l'étape D), une bille de brasure (40) est formée sur le contact brasé (30B) dans une étape de traitement F).

12. Procédé selon la revendication précédente, dans lequel à l'étape F), on utilise pour la bille de brasure (40) un matériau sélectionné parmi Sn, SnPb, SnAgCu, SnAgCuBi, SnZn et SnAg.

13. Procédé selon l'une des revendications précédentes, dans lequel à l'étape A), on utilise pour les passages de contact (10) un matériau sélectionné parmi Ag, Pd, Pt, AgPd, AgPt, AgPdPt, Ni et Cu.

14. Procédé selon l'une des revendications précédentes, pour la fabrication d'un varistor, dans lequel à l'étape A), on utilise pour le corps cru (5) un matériau sélectionné parmi ZnO-Bi et ZnO-Pr.

15. Procédé selon l'une des revendications 1 à 13, pour la fabrication d'un condensateur, dans lequel à l'étape A), on utilise pour le corps cru un matériau sélectionné parmi les classes de températures COG, X7R, Z5U, Y5V et HQM.

16. Procédé selon l'une des revendications précédentes, dans lequel à l'étape A), on utilise un matériau HTCC ou un matériau LTCC.

17. Procédé selon l'une des revendications précédentes, dans lequel à l'étape A), on utilise une céramique-ferrite comme matériau pour le corps cru.
